# EUROPÄISCHE PATENTSCHRIFT

(11) **EP 2 408 279 B1**
(45) Veröffentlichungstag und Bekanntmachung des Hinweises auf die Patenterteilung: **05.06.2013**
(21) Anmeldenummer: 11173981.9
(22) Anmeldetag: 14.07.2011
(51) Int. Cl.: H05K 1/02

(54) **Verbiegbare Metallkernleiterplatte**
Bendable metal core PCB
Châssis de circuits imprimés à cýur métallique incurvable

(30) Priorität: 14.07.2010 DE 102010027149
(43) Veröffentlichungstag der Anmeldung: 18.01.2012
(73) Patentinhaber: FELA Hilzinger GmbH, 78054 Villingen-Schwenningen (DE)
(72) Erfinder: Heiser, Eberhard, 78083 Dauchingen (DE)
(74) Vertreter: Patentanwälte Westphal, Mussgnug & Partner

(56) Entgegenhaltungen:
- EP-A1- 1 651 015
- WO-A2-2009/038950
- US-A- 5 434 362
- US-A1- 2004 118 595
- US-A1- 2005 190 531

## Beschreibung

Die Erfindung betrifft eine gebogene Metallkernleiterplatte mit den Merkmalen des Oberbegriffs des Anspruchs 1.

Eine solche gebogene Metallkernleiterplatte ist z.B. aus US 2004/0118595 A1 bekannt.

Andere Metallkernleiterplatten und ein Herstellverfahren hierfür sind beispielsweise aus DE 103 40 705 B4 bekannt. In der Figur 1 ist eine solche bekannte Metallkernleiterplatte im Schnitt dargestellt. Die Metallkernleiterplatte ist mit den Bezugszeichen 1 versehen und weist einen metallischen Träger 2 als Grundplatte auf. Dieser metallische Träger 2 kann beispielsweise aus Kupfer oder Aluminium bestehen und sorgt für eine optimale Wärmeableitung eines unmittelbar auf den metallischen Träger 2 aufsitzenden elektrischen Bauelements 10. Das Bauelement ist beispielsweise ein integrierter Schaltkreis oder ein elektrischer Schalter oder dergleichen. Das elektrische Bauelement 10 sitzt in einer Öffnung bzw. Aussparung 4 einer auf der oberen Hauptfläche A aufgebrachten Isolierschicht 3. Hierbei handelt es sich beispielsweise um eine polymere Isolierschicht 3. Auf dieser Isolierschicht 3 sitzen elektrische Leiterbahnen 7, welche ebenfalls als Leiterschicht aufgebracht ist. Die Isolierschicht 3 verbindet den metallischen Träger 2 fest mit der Leiterschicht 7. Das elektrische Bauelement 10 ist über Bonddrähte 11 mit den Leiterbahnen der elektrischen Leiterschicht 7 elektrisch in Verbindung. Die der Isolierschicht 3 abgewandte untere Hauptfläche des metallischen Trägers 2 ist mit dem Bezugzeichen B bezeichnet. Ein Verfahren zum Herstellen einer solchen Metallkernleiterplatte ist explizit in der DE 103 40 705 B4 offenbart, weswegen hierauf ausdrücklich Bezug genommen wird.

Eine andere Metallkernleiterplatte ist aus DE 36 40 952 A1 bekannt. Dort ist auf eine Aluminiumplatte 2 mit einer Dicke von 1 bis 3mm eine Isolierschicht aufgetragen, die eine Dicke von 2 bis 10µm aufweist. Auf der Oberfläche der isolierenden Schicht 3 ist eine elektrische Schaltung aufgebracht.

Diesen bekannten Metallkernleiterplatten bieten zwar eine optimale Wärmezufuhr für die darauf befindlichen elektrischen Bauteile. Die einzelnen elektrischen Bauteile sind jedoch allesamt in einer gemeinsamen Ebene auf dem metallischen Träger angeordnet, so dass hinsichtlich der Einsatzbereiche solcher Metallkernleiterplatten Grenzen gesetzt sind. So muss beispielsweise die auf der Metallkernleiterplatte befindliche Stromversorgungseinrichtung, z. B. eine Batterie, in der gleichen Ebene angeordnet sein, wie die übrigen elektrischen Komponenten, wie z. B. elektrische Schalter, Anzeigeeinrichtungen, lichtempfindliche Sensoren oder lichtaussendende Bauelemente.

Die Erfindung hat das Ziel, den Einsatzbereich solcher Metallkernleiterplatten weiter zu erhöhen.

Dieses Ziel wird durch eine Metallkernleiterplatte mit den Merkmalen des Anspruchs 1 erreicht.

Weiterbildungen einer solchen Metallkernleiterplatte sind Gegenstand der Unteransprüche.

Der wesentliche Kern der Erfindung besteht also darin, die an sich bekannte Metallkernleiterplatte mit Biegebereichen oder zumindest einem Biegebereich zu versehen, in welchen der metallische Träger im Vergleich zu übrigen Metallkernleiterplatten verdünnt ausgebildet ist. Dieses verdünnte Ausbilden führt dazu, dass die Metallkernleiterplatte in diesem Biegebereich besonders flexibel ist und daher leicht verbogen werden kann, so dass die einzelnen elektrischen Bauteile zueinander in nahezu beliebige Lage gebracht werden können. Um das Verbiegen der Metallkernleiterplatte im Biegebereich weiter zu erleichtern, sind Schlitze vorgesehen. Die Schlitze verlaufen dabei beidseitig der elektrischen Leiterbahn im Biegebereich. Die elektrischen Leiterbahnen verlaufen in einer besonderen Ausbildung der Erfindung orthogonal oder zumindest annähernd orthogonal zu einer Biegekante des Biegebereichs.

In einer Weiterbildung der Erfindung ist vorgesehen, dass im Biegebereich zumindest teilweise die Isolierschicht samt elektrischen Leiterbahnen vorgesehen ist.

Eine besonders biegefreundliche Metallkernleiterplatte wird dadurch erreicht, dass die die elektrische Leiterbahnen tragende Isolierschicht im Biegebereich vollständig frei liegt, d. h. dass unterhalb der Isolierschicht keine oder zumindest nahezu keine, also nur ein sehr dünner metallischer Träger liegt, der ein einfaches Biegen der Metallkernleiterplatte in diesem Bereich sicherstellt.

Zweckmäßigerweise wird eine solche Metallkernleiterplatte dadurch hergestellt, dass diese zunächst so wie in der eingangs genannten Veröffentlichung DE 103 40 705 beschrieben hergestellt wird. Anschließend wird durch ein geeignetes Werkzeug, z. B. ein Fräswerkzeug, der metallische Träger im Biegebereich verdünnt.

Es hat sich als vorteilhaft erwiesen, im Biegebereich die Metallkernleiterplatte von beiden Seiten her zu verdünnen, und zwar dort, wo keine elektrischen Leiterbahnen verlaufen.

Selbstverständlich kann die Metallkernleiterplatte mehrere der genannten Biegebereiche aufweisen, so dass die unterschiedlichen elektrischen Bauteile und Komponenten in mehr als zwei Ebenen zueinander unter Umständen auch verdreht zueinander angeordnet werden können.

Ein Verfahren zum Herstellen einer solchen Metallkernleiterplatte sieht vor, dass auf dem Metallträger die Isolierschicht aufgebracht und auf dieser Isolierschicht die elektrische Leiterbahnen platziert werden. In einem Biegebereich unterhalb der elektrischen Leiterbahnen wird die Metallkernleiterplatte so bearbeitet, dass der metallische Träger von seiner der Isolierschicht abgewandten Hauptfläche nahezu vollständig bis zur Isolierschicht entfernt vorzugsweise weggefräst wird, und in Biegebereich beidseitig der elektrischen Leiterbahn werden Schlitzen die die Metallkernleiterplatte durchtrennen eingearbeitet.

Die erfindungsgemäße Metallkernleiterplatte wird im Folgenden anhand eines Ausführungsbeispieles im Zusammenhang mit weiteren Figuren näher erläutert. Es zeigen:
- Figur 1: die Schnittansicht durch eine bereits bekannte Metallkernleiterplatte mit metallischem Träger, darauf sitzender Isolierschicht und auf der Isolierschicht befindlichen Leiterbahnen,
- Figur 2: eine ähnliche Metallkernleiterplatte wie in Figur 1 im nichtgebogenen Zustand in perspektivischer Darstellung mit aufgesetzten elektrischen Bauelementen,
- Figur 3: die aus Figur 2 bekannte Metallkernleiterplatte im gebogenen Zustand,
- Figur 4: einen Schnitt der Metallkernleiterplatte entlang der Schnittlinie IV-IV von Figur 2,
- Figur 5: eine ähnliche Schnittansicht wie in Figur 4, wobei jedoch einzelne Bereiche der Metallkernleiterplatte verdünnt sind, und
- Figur 6: eine schematische Darstellung der in den Figuren 1 bis 5 gezeigten Metallkernleiterplatte im Biegebereich.

In den nachfolgenden Figuren bezeichnen, sofern nicht anders angegeben, gleiche Bezugszeichen gleiche Teile mit gleicher Bedeutung.

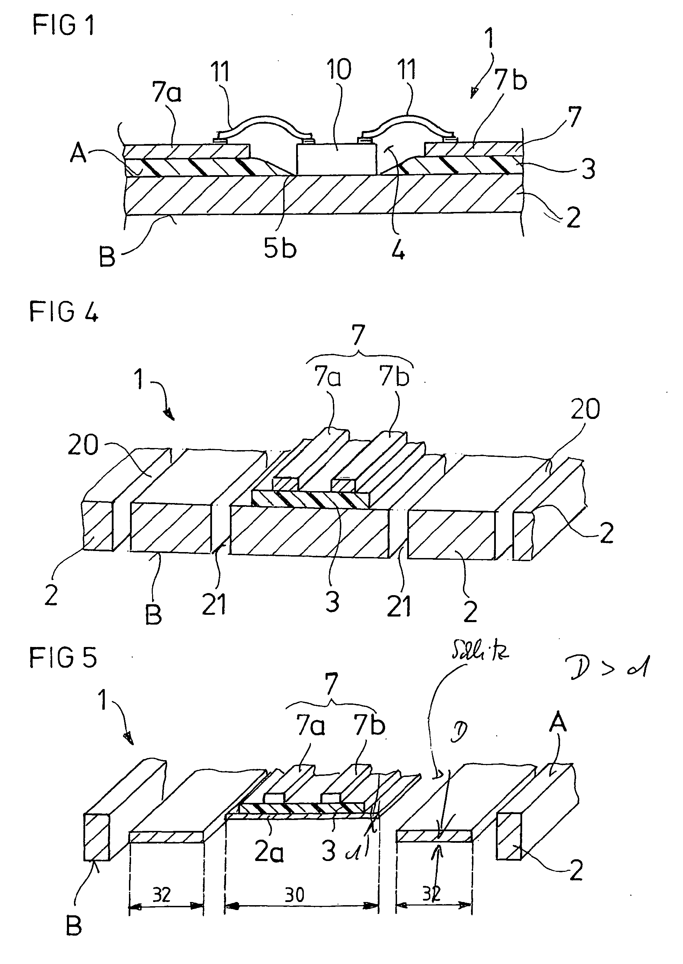

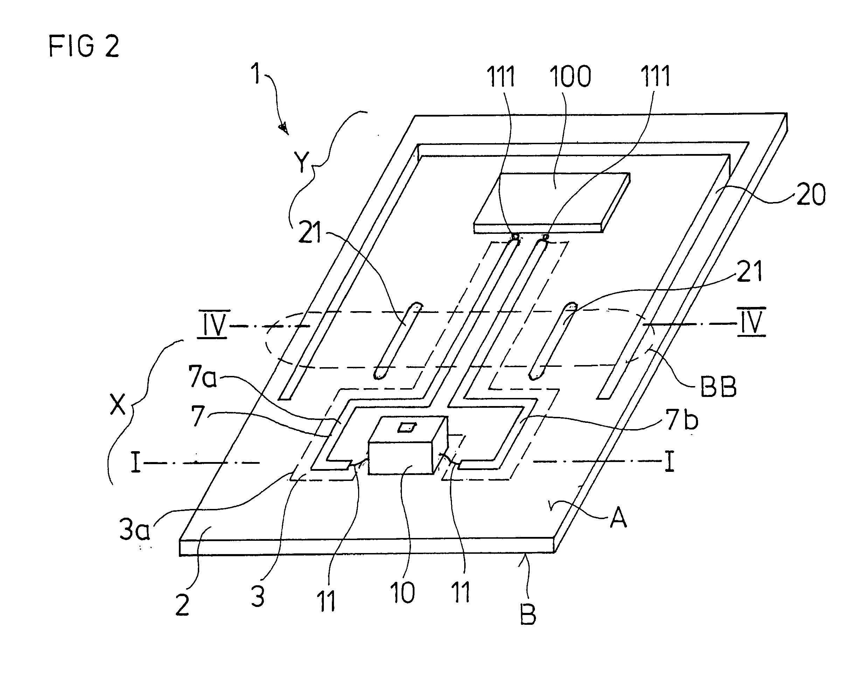

Figur 2 zeigt eine Metallkernleiterplatte 1 in perspektivischer Darstellung, welche entlang der Schnittlinie I-I den Aufbau gemäß Figur 1 haben kann. Die Metallkernleiterplatte 1 verfügt über einen plattenförmigen, metallischen Träger 2, der aus Aluminium, Kupfer oder ähnlichem gut wärmeleitenden Metall besteht. Der metallische Träger 2 weist eine obere Hauptfläche A und eine untere Hauptfläche B auf. Auf der oberen Hauptfläche A ist eine Isolierschicht 3 aufgebracht, die entsprechend der gestrichelten Linie 3a strukturiert ist. Auf dieser strukturierten Isolierschicht 3 sind elektrische Leiterbahnen 7a und 7b platziert. Die elektrischen Leiterbahnen 7a, 7b können als elektrische Leiterschicht 7, die in einem an sich bekannten Verfahren strukturiert ist, auf die Isolierschicht 3 aufgetragen werden. Das Ausführungsbeispiel von Figur 2 zeigt zwei solcher elektrischer Leiterbahnen 7a, 7b. Anzumerken ist, dass die elektrischen Leiterbahnen 7a und 7b nicht gezwungener Weise in Form einer Leiterbahnenschicht aufgebracht werden müssen. Es besteht auch die Möglichkeit, die elektrischen Leiterbahnen 7a, 7b zum Beispiel mittels einer elektrisch leitenden Paste leiterbahnbezogen aufzubringen.

Die beiden elektrischen Leiterbahnen 7a, 7b verbinden zwei elektrische Bauteile 10, 100, welche unmittelbar auf der Hauptfläche A des metallischen Trägers 2 sitzen. Hierfür sind die elektrischen Leiterbahnen 7a, 7b über Bonddrähte 11 und 111 mit Anschlusskontakten des elektrischen Bauelements 10, welches im vorderen Abschnitt X der Metallkernleiterplatte 1 angeordnet ist, und mit Bonddrähten 111 mit dem elektrischen Bauelement 100, das sich im hinteren Abschnitt Y der Metallkernleiterplatte 1 befindet, elektrisch verbunden.

Das elektrische Bauteil 10 kann beispielsweise eine Schalteinrichtung mit integrierter Batterie und das elektrische Bauelement 100 eine elektronische Anzeigeeinrichtung sein. Selbstverständlich sind auch andere elektrische Bauelemente hier einsetzbar. Das elektrische Bauelement 100 kann beispielsweise auch eine LED, ein Sensor eine integrierte Schaltung oder dergleichen sein, welche an das elektrische Bauelement 10 angeschlossen ist.

Die bisher erläuterte Anordnung entspricht den eingangs erläuterten und bekannten Metallkernleiterplatten. Im Unterschied zu den bekannten Metallkernleiterplatten weist die in Figur 2 dargestellte Metallkernleiterplatte jedoch einen besonders aufbereiteten Biegebereich BB auf, welcher zwischen den beiden elektrischen Bauelementen 10, 100 angeordnet ist. Durch diesen Biegebereich BB verlaufen die beiden elektrischen Leiterbahnen 7a und 7b. Im Biegebereich BB verlaufen links und rechts von den beiden Leiterbahnen 7a, 7b Schlitze 21, die zumindest annähernd parallel zu den Leiterbahnen 7a, 7b liegen. Zusätzlich verläuft ein U-förmiger Schlitz 20, welcher das im Bereich Y der Metallkernleiterplatte 1 liegende elektrische Bauelement 100 umgreift. Die beiden längsförmigen Schenkel des Schlitzes 20 verlaufen parallel zueinander und enden etwa im unteren Bereich X der Metallkernleiterplatte 1.

In Figur 4 ist die Schnittansicht entlang der Schnittlinie IV-IV der Metallkernleiterplatte 1 von Figur 2, wie sie bisher erläutert wurde, dargestellt. Es sind deutlich die Schlitze 21 und 22, die den metallischen Träger 2 vollständig durchtrennen, zu erkennen, sowie die im mittleren Bereich der Metallkernleiterplatte aufgebrachte Isolierschicht 3, auf der die beiden Leiterbahnen 7a, 7b verlaufen.

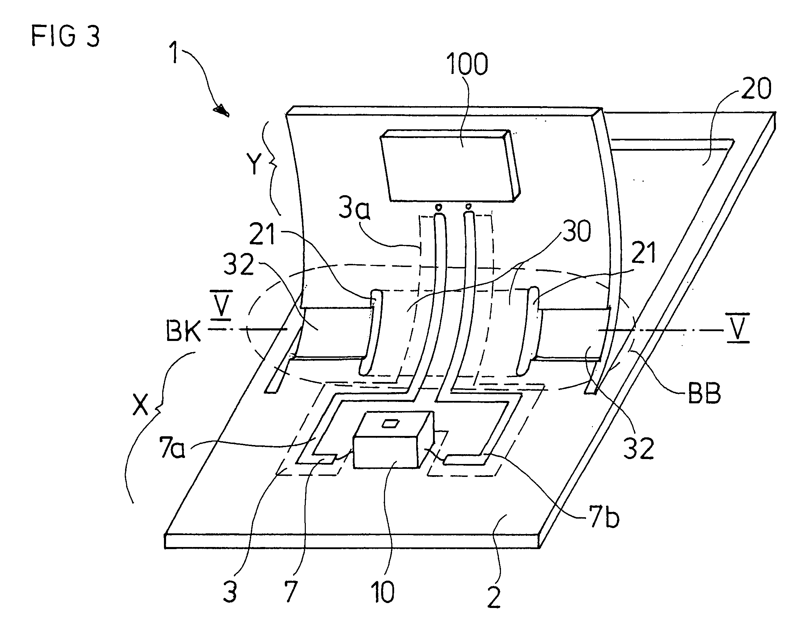

Figur 3 zeigt die aus Figur 2 bekannte Metallkernleiterplatte 1, wobei jedoch das elektrische Bauelement 100 zusammen mit dem durch den U-förmigen Schlitz 20 definierten Bereich der Metallkernleiterplatte 1 aus seiner in Figur 2 dargestellten Ebene um etwa 90° nach oben herausgebogen ist. Das Biegen erfolgt entlang einer Biegekante BK, welche innerhalb des Biegebereichs BB liegt.

Um ein solches Herausbiegen zu ermöglichen, ist die Metallkernleiterplatte 1 im Biegebereich B entlang der Biegekante BK besonders gestaltet. Dies wird in Zusammenschau der Figur 3 und Figur 5 besonders deutlich. Die Metallkernleiterplatte 1 ist nämlich im Biegebereich BB durch gezieltes Bearbeiten des metallischen Trägers 2 aufbereitet. So ist, wie die Schnittdarstellung von Figur 5 entlang des Schnittes entlang der Schnittstelle V-V von Figur 3 zeigt, der metallische Träger 2 unterhalb der Isolierschicht 3 entweder vollständig entfernt oder, wie in Figur 5 angedeutet, nur noch sehr dünn vorhanden. Dies wird dadurch erreicht, dass ein geeignetes Fräserwerkzeug von der unteren Hauptfläche B her kommend den metallischen Träger 2 bis zum Erreichen der Isolierschicht 3 oder knapp davor abfräst.

Um ein bewusstes Verbiegen der Metallkernleiterplatte 1 im Biegebereich BB zu erleichtern, kann in den neben den Schlitzen 21 liegenden Bereichen zusätzlich mit einem Fräswerkzeug von unten und/oder oben her, also von der unteren Hauptfläche B und/oder der oberen Hauptfläche A her ebenfalls das Material des metallischen Trägers 3 so abgetragen werden, dass ein verhältnismäßig dünner Streifen des metallischen Trägers 2 verbleibt. Dieser Bereich ist in Figur 5 mit dem Bezugszeichen 32 versehen, während der unter der Isolierschicht 3 liegende freie oder nahezu freie Bereich mit dem Bezugszeichen 30 markiert ist.

Erst dieses Verdünnen oder Freilegen des Metallkernträgers 2 ermöglicht es, dass das elektrische Bauelement 100 samt metallischen Träger 2 in der in Figur 3 gezeigten Art und Weise aus seiner ursprünglichen Ebene herausgebogen werden kann, ohne dass die elektrischen Leiterbahnen 7a, 7b und/oder der metallische Träger 2 brechen. Der freie bzw. nahezu freigelegte Bereich ist in Figur 3 ebenfalls mit dem Bezugszeichen 30 versehen und punktiert gekennzeichnet. Der im Zusammenhang mit Figur 5 erläuterte verdünnte Bereich des metallischen Trägers 2 ist in Figur 3 mit dem Bezugszeichen 32 versehen und schraffiert gekennzeichnet.

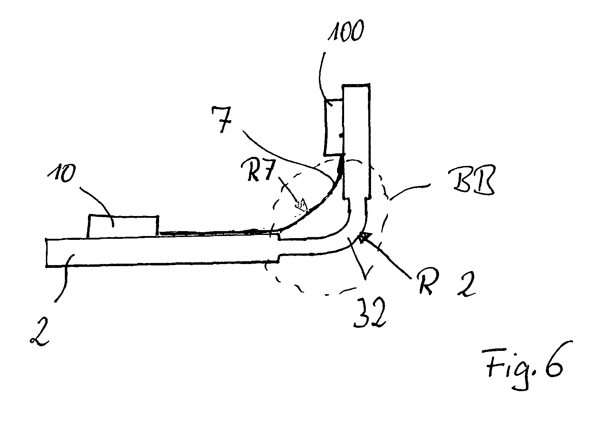

In Figur 6 ist die aus den vorgenannten Figuren bekannte Metallkernleiterplatte 2 nochmals in Schnittdarstellung dargestellt. Die bereits bekannten Bezugszeichen stehen weiter für die gleichen Teile. Aus Figur 6 ist deutlich zu erkennen, dass im Biegebereich BB der Biegeradius R2 des verdünnten Bereichs 32 des Metallträgers 2 deutlich kleiner ist als der Biegeradius R7 der Leiterschicht 7, also der die Leiterbahnen 7a, 7b tragenden Leiterschicht. Dieser geringere Biegeradius R7 der Leiterschicht ist insbesondere deshalb vorteilhaft, da die Leiterbahnen aufgrund der links und rechts von den Leiterbahnen vorgesehenen Schlitze ihren "eigenen" Biegeradius definieren können. Der geringere Biegeradius R7 beansprucht vorteilhafterweise die Leiterschicht 7 und darauf befindlichen Leiterbahnen 7a, 7b hinsichtlich von Biegespannungen weniger.

Obwohl im Zusammenhang mit den vorgenannten Figuren immer davon die Rede war, dass im Biegebereich BB beidseitig die elektrischen Leiterbahnen 7a, 7b verlaufen, liegt es selbstverständlich auch im Rahmen der Erfindung, dass einer dieser Schlitze entfällt bzw. dieser Schlitz unendlich groß gewählt wird, so dass damit die elektrischen Leiterbahnen an dieser Seite den Rand der Metallkernleiterplatte bilden. Dies führt dazu, dass die Leiterschicht 7 mit den elektrischen Leiterbahnen 7a, 7b nur einen einzigen Schlitz aufweist, der zwischen dieser Leiterschicht und der Metallkernleiterplatte angeordnet ist.

### Bezugszeichenliste

- 1: Metallkernleiterplatte
- 2: Metallträger
- 3: Isolierschicht
- 3a: Umrandung von 3
- 4: Aussparung
- 5a: Übergangsbereich von 3 zu 4
- 5b: Übergangsbereich von 3 zu 4
- 7: Leiterschicht
- 7a: Leiterbahn
- 7b: Leiterbahn
- 10: elektrisches Bauelement
- 11: Bonddrähte
- 20: Schlitz
- 21: Schlitz
- 30: freier oder freigelegter Bereich
- 32: verdünnter Bereich des Metallträgers 2
- 100: elektrisches Bauelement
- 111: Bonddraht
- A: erste Hauptfläche
- B: zweite Hauptfläche
- X: vorderer Bereich
- Y: hinterer Bereich
- BB: Biegebereich
- BK: Biegekante
- R2: Biegeradius des Metallträgers 2
- R7: Biegeradius der Leiterschicht 7
- I-I: Schnittlinie
- IV-IV: Schnittlinie
- V-V: Schnittlinie

## Patentansprüche

1. Gebogene Metallkernleiterplatte (1) mit einem metallischen Träger (2), auf dem auf mindestens einer seiner Hauptflächen (A, B) eine Isolierschicht (3) mit darüber angeordneten elektrischen Leiterbahnen (7a, 7b) sitzt, wobei die Metallkernleiterplatte (1) einen Biegebereich (BB) aufweist, in welchen der metallische Träger (2) im Vergleich zur übrigen Metallkernleiterplatte (1) verdünnt ausgebildet ist
**dadurch gekennzeichnet, dass** im Biegebereich (BB)Schlitze (20, 21) vorgesehen sind,
dass die Schlitze (20, 21) die gesamte Metallkernleiterplatte (1) durchtrennen, und dass die Schlitze 20, 21) im Biegebereich (BB) beidseitig der elektrischen Leiterbahnen (7a, 7b) verlaufen.

2. Gebogene Metallkernleiterplatte nach Anspruch 1,
**dadurch gekennzeichnet, dass** im Biegebereich (BB) zumindest ein Teil der Isolierschicht (3) samt elektrischen Leiterbahnen (7a, 7b) angeordnet ist.

3. Gebogene Metallkernleiterplatte nach Anspruch 1 oder 2,
**dadurch gekennzeichnet, dass** die die elektrischen Leiterbahnen (7a, 7b) tragende Isolierschicht (3) im Biegebereich (BB) vollständig frei liegt.

4. Gebogene Metallkernleiterplatte nach einem der Ansprüche 1 bis 3,
**dadurch gekennzeichnet, dass** im Biegebereich (BB) der metallische Träger (2) von seinen beiden Hauptflächen (AB) her verdünnt ist.

5. Gebogene Metallkernleiterplatte nach einem der Ansprüche 1 bis 4,
**dadurch gekennzeichnet, dass** der Biegebereich (BB) eine Biegekante (BK) aufweist, zu denen die elektrischen Leiterbahnen (7a, 7b) orthogonal verlaufen.

6. Gebogene Metallkernleiterplatte nach einem der Ansprüche 1 bis 5,
**dadurch gekennzeichnet, dass** diese mehrere Biegebereiche (BB) aufweist.

7. Verfahren zum Herstellen einer Metallkernleiterplatte nach einem der Ansprüche 1 bis 6,
**dadurch gekennzeichnet, dass** auf dem Metallträger (2) eine Isolierschicht (3) aufgebracht und auf dieser Isolierschicht elektrische Leiterbahnen (7a, 7b) platziert werden, wobei in einem Biegebereich (BB) unterhalb der elektrischen Leiterbahnen (7a, 7b) die Metallkernleiterplatte verdünnt wird, indem der metallische Träger (2) von seiner der Isolierschicht (3) abgewandten Hauptfläche (B) her nahezu vollständig bis zur Isolierschicht entfernt wird, und dass im Biegebereich (BB) beidseitig der elektrischen Leiterbahnen (7a, 7b) Schlitze (20, 21) die die Metallkernleiterplatte (1) durchtrennen eingearbeitet werden.

8. Verfahren zum Herstellen einer Metallkernleiterplatte nach Anspruch 7,
**dadurch gekennzeichnet, dass** im Biegebereich (BB) der metallische Träger (2) in den Bereichen, in denen keine Leiterbahnen (7a, 7b) verlaufen, von beiden Hauptflächen (AB) her mittels eines Werkzeuges verdünnt wird.

## Claims

1. A bent metal-core printed circuit board (1) with a metallic support (2) on which on at least one of the main faces (A, B) thereof is mounted an insulation layer (3) with electrical conductor tracks (7a, 7b) arranged thereabove, wherein the metal-core printed circuit board (1) has a bending area (BB) in which the metallic support (2) is made thin as compared with the rest of the metal-core printed circuit board (1), **characterized in that** slots (20, 21) are provided in the bending area (BB), the slots (20, 21) separate the entire metal-core printed circuit board (1), and the slots (20, 21) extend in the bending area (BB) on both sides of the electrical conductor tracks (7a, 7b).

2. A bent metal-core printed circuit board according to claim 1, **characterized in that** at least part of the insulation layer (3) is arranged with the electrical conductor tracks (7a, 7b) in the bending area (BB).

3. A bent metal-core printed circuit board according to claim 1 or 2, **characterized in that** the insulation layer (3) supporting the electrical conductor tracks (7a, 7b) is completely exposed in the bending area (BB) .

4. A bent metal-core printed circuit board according to any one of claims 1 to 3, **characterized in that** the metallic support (2) is thinned from the two main faces (AB) thereof in the bending area (BB).

5. A bent metal-core printed circuit board according to any one of claims 1 to 4, **characterized in that** the bending area (BB) has a bending edge (BK) with respect to which the electrical conductor tracks (7a, 7b) extend at a right angle.

6. A bent metal-core printed circuit board according to any one of claims 1 to 5, **characterized in that** it comprises a plurality of bending areas (BB).

7. A method of producing a metal-core printed circuit board according to any one of claims 1 to 6, **characterized in that** an insulating layer (3) is applied to the metallic support (2) and electrical conductor tracks (7a, 7b) are placed on this insulating layer (3), wherein the metal-core printed circuit board is thinned in a bending area (BB) below the electrical conductor tracks (7a, 7b) by the metallic support (2) being removed from its main face (B) remote from the insulating layer (3) almost completely as far as the insulating layer, and slots (20, 21) which separate the metal-core printed circuit board (1) are formed in the bending area (BB) on both sides of the electrical conductor tracks (7a, 7b).

8. A method of producing a metal-core printed circuit board according to claim 7, **characterized in that** in the areas in which no conductor tracks (7a, 7b) extend the metallic support (2) is thinned from the two main faces (AB) in the bending area (BB) by means of a tool.

## Revendications

1. Plaquette de circuits imprimés à noyau métallique incurvé (1) comportant un support métallique (2) sur lequel s'appuie, sur au moins l'une de ses surfaces principales (A, B) une couche isolante (3) sur laquelle sont montées des pistes électriquement conductrices (7a, 7b), la plaquette de circuits imprimés à noyau métallique (1) comportant une zone de flexion (BB) dans laquelle le support métallique (2) est plus mince que la partie restante de la plaquette de circuits imprimés à noyau métallique (1),
**caractérisée en ce que**
dans la zone de flexion (BB) il est prévu des fentes (20, 21), ces fentes (20, 21) traversant la totalité de la plaquette de circuits imprimés à noyau métallique (1), et s'étendant dans la zone de flexion (BB) des deux côtés des pistes électriquement conductrices (7a, 7b).

2. Plaquette de circuits imprimés à noyau métallique incurvé conforme à la revendication 1,
**caractérisée en ce que**
dans la zone de flexion (BB) est montée au moins une partie de la couche isolante (3), y compris les pistes électriquement conductrices (7a, 7b).

3. Plaquette de circuits imprimés à noyau métallique incurvé conforme à la revendication 1 ou 2,
**caractérisée en ce que**
la couche isolante (3) portant les pistes électriquement conductrices (7a, 7b) est totalement dégagée dans la zone de flexion (BB).

4. Plaquette de circuits imprimés à noyau métallique incurvé conforme à l'une des revendications 1 à 3,
**caractérisée en ce que**
dans la zone de flexion (BB) le support métallique (2) est aminci à partir de ses deux surfaces principale (AB).

5. Plaquette de circuits imprimés à noyau métallique incurvé conforme à l'une des revendications 1 à 4,
**caractérisée en ce que**
la zone de flexion (BB) comporte une arête de flexion (BK) perpendiculairement à laquelle s'étendent les pistes électriquement conductrices (7a, 7b).

6. Plaquette de circuits imprimés à noyau métallique incurvé conforme à l'une des revendications 1 à 5,
**caractérisée en ce qu'**
elle comporte plusieurs zones de flexion (BB).

7. Procédé d'obtention d'une plaquette de circuits imprimés à noyau métallique conforme à l'une des revendications 1 à 6,
**caractérisée en ce qu'**
une couche isolante (3) est appliquée sur un support métallique (2), et sur cette couche isolante sont positionnées des pistes électriquement conductrices (7a, 7b), la plaquette de circuits imprimés à noyau métallique étant amincie dans une zone de flexion (BB) située au-dessous des pistes électriquement conductrices (7a, 7b), en éliminant le support métallique (2) à partir de sa surface principale (B) opposée à la couche isolante (3) essentiellement complètement jusqu'à la couche isolante, et, dans la zone de flexion (BB), de chaque côté des pistes électriquement conductrices (7a, 7b) sont réalisées des fentes (20, 21) qui traversent la plaquette de circuits imprimés à noyau métallique (1).

8. Procédé d'obtention d'une plaquette de circuits imprimés à noyau métallique conforme à la revendication 7,
**caractérisée en ce que**
dans la zone de flexion (AB) le support métallique (2) est aminci au moyen d'un outil sur ses deux surfaces principale dans les zones dans lesquelles ne s'étend aucune piste conductrice (7a, 7b).
